# EUROPEAN PATENT SPECIFICATION

(11) **EP 2 084 739 B1**
(45) Date of publication and mention of the grant of the patent: **20.12.2017**
(21) Application number: 07825728.4
(22) Date of filing: 31.08.2007
(51) Int. Cl.: H01L 21/56, H01L 23/00, H01L 23/16, H01L 23/24, H01L 23/31

(54) **FLIP CHIP SEMICONDUCTOR PACKAGE WITH ENCAPSULANT RETAINING STRUCTURE AND STRIP**
HALBLEITERFLIPCHIPPACKUNG MIT VERKAPSELUNGSHALTESTRUKTUR UND STREIFEN
BOITIER SEMICONDUCTEUR A PUCE RETOURNEE DOTE D'UNE STRUCTURE DE RETENUE D'ENCAPSULANT ET D'UNE BANDE

(30) Priority: 31.08.2006 US 469194; 30.08.2007 US 847813
(43) Date of publication of application: 05.08.2009
(73) Proprietor: ATI Technologies ULC, Markham, Ontario L3T 7X6 (CA)
(72) Inventor: MCLELLAN, Neil, R., Toronto, ON M2K 3B8 (CA); CHAN, Vincent, K., Richmond Hill, ON L4S 2G6 (CA); TOPACIO, Roden, R., Markham, ON L3R 4S8 (CA)
(74) Representative: Robinson, David Edward Ashdown
(86) International application number: PCT/IB2007/003615
(87) International publication number: WO 2008/026077

(56) References cited:
- WO-A2-02/47162
- WO-A2-2004/043130
- JP-A- 61 112 358
- US-A1- 2004 125 578
- US-A1- 2004 150 118
- US-A1- 2005 035 440
- US-A1- 2005 047 094
- US-A1- 2005 121 757
- US-A1- 2005 280 139
- US-B1- 6 472 762
- US-B1- 6 816 654
- US-B2- 6 890 635

## Description

### CROSS-REFERENCE TO RELATED APPLICATIONS

This application claims priority of U.S. Patent Application No. 11/847,813 filed August 30, 2007, which is a continuation-in-part, and claims the benefit of and priority from, U.S. patent application No. 11/469,194 filed August 31, 2006.

### FIELD OF THE INVENTION

The present invention relates generally to integrated circuit packaging and more particularly to flip chip semiconductor packages.

### BACKGROUND OF THE INVENTION

Integrated circuits are formed on a semiconductor die and packaged for incorporation into a variety of end products. Examples of semiconductor integrated circuit packages include general purpose processors, graphics processing units, memory chips and a variety of specialized application specific integrated circuits (ASICs). International Patent Publication No. WO 02/47162 describes a microelectronic package.

Packaging integrated circuits typically entails placing a die on a substrate that acts as a carrier and forming electrical connections between input-output (I/O) pads on the die and conductive traces on the carrier. The carrier may take the form of a lead- frame or a circuit board. Balls or pins which are suitable for mounting the package on an external device such as a motherboard, a computer expansion cards, or the like are attached to the substrate. The conductive traces provide electrical interconnection to balls or pins on the carrier.

A variety of packaging techniques are commonly used. These include flip-chip packaging and wire bonding. In wire bonding, the inactive surface of the die that contains no circuitry is attached to the carrier, and wires are bonded to die pads from the upward facing active surface of the die to conductive traces on the carrier.

In flip chip packaging however, the active surface of the die, proximate the integrated circuit, faces the substrate when the die is attached. Small amounts of solder - referred to as solder bumps - are formed on each die pad of the die and used to connect each die pad on the die to a corresponding conductive trace on the carrier. Under bump metallization (UBM) is typically formed over each pad, to provide a low resistance electrical connection to solder bumps. Each conductive trace connects to a corresponding solder ball to provide external I/O connection points. The solder balls are used to attach the semiconductor package to an external printed circuit board (PCB).

Flip-chip packaging is generally regarded as providing smaller package sizes, higher performance, greater input/output (I/O) density and lower cost as compared to wire-bonding.

Multiple flip chip packages may be formed in a strip, as for example detailed in US Patent Publication 2005/0121757. In this way, multiple dies may be placed on a substrate, and thereafter singulated into individual chip packages. The stiffener may be similarly formed as a strip that is affixed to the substrate prior to singulation.

However, solder bumps connecting the die to the substrate in such packaging may be the subject of significant thermo-mechanical stress. A common source of such stress is a mismatch in the coefficient of thermal expansion (CTE) between the die and the carrier. That is, in operation, heat is invariably generated by integrated circuits. This heat causes both the die and the substrate/carrier to expand. As the CTE for the die may be substantially different from the CTE of the carrier, this dissimilar rate of expansion causes thermo-mechanical stress on the solder bumps. If the stress is sufficiently large, it may damage the physical connection provided by solder bumps and as a result electrical connectivity may be lost.

One well known technique to reduce thermo-mechanical stress in flip-chip attachments is underfilling. Underfilling entails introducing additional material (called underfill) typically in the form of a viscous adhesive liquid such as epoxy resin, between the die and the carrier after the die is attached to the carrier. This reduces the stress on the solder bumps, thereby improving the package's reliability. US Patent Publication No. US2005/0047094 describes a molding process in which a resin compound forms an encapsulation body that encapsulates a clip.

Typically, capillary action, in association with liquid viscosity, seeps dispensed encapsulant inwards to open spaces between the substrate and die. Once the encapsulant is in place, it is cured to create a permanent bond. While different techniques are known to prevent the formation of voids in the gap, underfilling remains time-consuming. As die sizes increase, so does the number of solder bumps used to connect the die to the substrate. In some instances, because of characteristics of the encapsulant, a dispensing machine must be used sequentially to place at different time intervals fractions of the needed encapsulant. Often five to six passes of dispense, seep, and dispense again must be taken to form clean void free underfill structures. Further, known methods place underfill around the entire perimeter of the semiconductor die where the material flows toward the die's center. Although less viscous encapsulants may speed the underfill process, less viscous encapsulant may seep at higher rates but is likely to spread on the circuit board in other directions. Not surprisingly, increasing the speed by which encapsulant may be applied is desirable.

What is needed is a new package that may reduce the time needed to fill this space by limiting the number of passes of dispenses needed.

### SUMMARY OF THE INVENTION

Exemplary of an embodiment of the present invention, an integrated circuit package comprises a substrate with a first surface and a second surface in opposition to the first surface; an encapsulant retention structure coupled to the first surface; and a die positioned adjacent to the encapsulant retention structure. An encapsulant is interposed between at least a portion of the die and the encapsulant retention structure and is in contact with the encapsulant retention structure. The encapsulant retention structure further acts as a stiffener to minimize package warpage.

In accordance with another aspect of the present invention, an integrated circuit package, comprises a substrate; a die coupled to the substrate; at least one passive electronic component coupled to the substrate; and a stiffener comprising a top surface and a bottom surface, the bottom surface coupled to the substrate and at least partly surrounding the passive electronic component.

In accordance with another aspect of the present invention, there is provided An integrated circuit package strip, comprising: a plurality of integrated circuit packages, wherein at least one integrated circuit package in the strip has four lateral sections and where the integrated circuit package shares at least two of the four lateral sections with different integrated circuit packages along the strip.

In accordance with a further aspect of the present invention, there is provided a method of making an integrated circuit package strip. The method comprises attaching an encapsulant retention structure having a plurality of openings each adapted to receive a die to a substrate; placing the die in each of the plurality of openings; placing an encapsulant between a side wall of the die and the encapsulant retention structure and in contact with the encapsulant retention structure; and curing the encapsulant.

Other aspects and features of the present invention will become apparent to those of ordinary skill in the art upon review of the following description of specific embodiments of the invention in conjunction with the accompanying figures.

### BRIEF DESCRIPTION OF THE DRAWINGS

In the figures which illustrate by way of example only, embodiments of the present invention,
**FIG. 1** is a side cross-sectional view of an integrated circuit package exemplary of an embodiment of the present invention;
**FIG. 2** is a enlarged fragmentary cross-sectional view of the integrated circuit package as shown by section **2** on **FIG. 1****;**
**FIG. 3** is a side cross-sectional view of an integrated circuit package with openings for passive electronic components exemplary of another embodiment of the present invention;
**FIG. 4** is a top view of the integrated circuit package with openings for passive electronic components shown in **FIG. 3** along the cut line **3-3;**
**FIG. 5** is a side cross-sectional view of an integrated circuit package with recessed openings for passive electronic elements exemplary of another embodiment of the present invention;
**FIG. 6** is a top view of the integrated circuit package with recessed openings for passive electronic elements shown in **FIG. 5** along the cut line **6-6;**
**FIG. 7** is a side cross-sectional view of an integrated circuit package strip exemplary of another embodiment of the present invention as shown on **FIG. 8** along the cut line **7-7.**
**FIG. 8** is a partial top view of the integrated circuit package strip shown on **FIG. 7****;**
**FIGS. 9-12** are elevation schematic views of a method for making an integrated package strip in manners exemplary of an embodiment of the present invention;
**FIG. 13** is a bottom view of the stiffener material used in making an integrated package strip in accordance with **FIGS. 9-12** as shown on **FIG. 12** along cut line **13-13;**
**FIG. 14** is a diagram of a method for making an integrated package strip in accordance to an embodiment of the present disclosure; and
**FIG. 15** is a diagram of a method for making an integrated package in accordance to an embodiment of the present disclosure.

### DETAILED DESCRIPTION

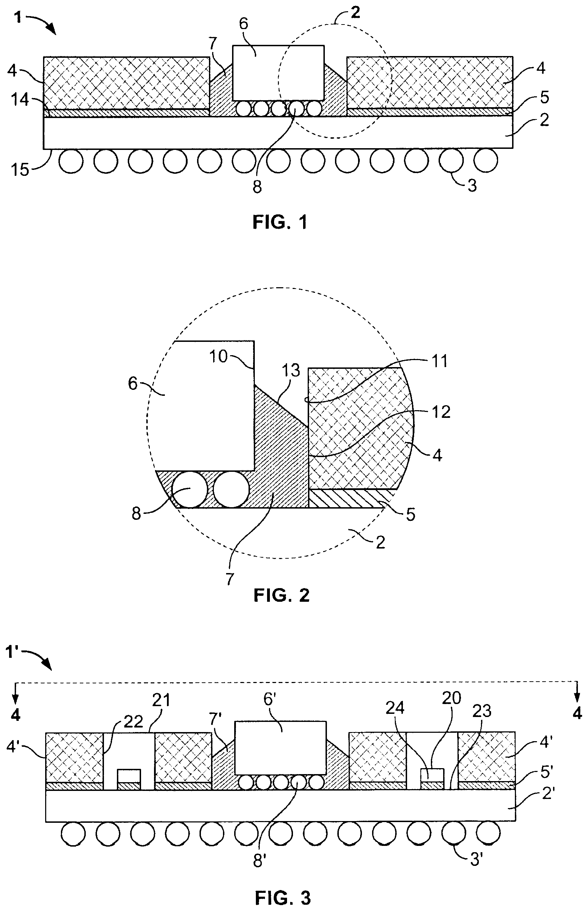

**FIG. 1** is a side cross-sectional view of an semiconductor integrated circuit package **1,** exemplary of an embodiment of the present invention.

Semiconductor integrated circuit package **1** may, for example, be a microprocessor, a graphics processor, an application specific integrated circuit (ASIC) or any other integrated electronic circuit, known to those of ordinary skill.

As illustrated, package **1,** also described as an integrated circuit ("IC") package 1, is formed by a semiconductor die **6** mounted on a carrier formed by substrate **2** having a first surface **14** and a second surface **15** in opposition to the first surface **14.** While substrate **2** is shown to be horizontal, it is understood by one of ordinary skill that package **1** may be used and manufactured, when possible, in any orientation and may include asperities, surface finishes, recesses, grooves, bumps, or even overall irregularly shaped geometries.

Substrate **2** is a carrier for die **6,** and may be formed as a BT substrate or any other type of printed circuit board, etched wiring board, laminate, or the like made illustratively of one or more layers of ceramic, paper impregnated with phenolic resin such as FR-2, woven fiberglass mat impregnated with a flame retardant epoxy resin such as FR-4, plastic with low dielectric constant such as Teflon, polyimide, polystyrene and cross-linked polystyrene, conductive core layers made of copper, aluminum or other conductive material, polyimide film layers, ceramic-based materials such as bonded copper, and insulated metal and metal-based substrates. In one alternate embodiment, substrate **2** may be coreless, made of successive layers of an insulating layer, placed in contact with a dielectric layer formed over a circuit layer made of relatively low dielectric constant and good fluidity, such as resin-based material such as ajinomoto build-up film (ABF). However any suitable material may be used.

Die **6** is a semiconductor die that holds an integrated circuit formed thereon. Die pads (not shown) provide electrical contacts to the integrated circuit. Die **6** is thermally and electrically coupled to substrate **2** by a series of electrical contacts **8** or bumps. Electrical contacts **8** in **FIG. 1** are depicted as small spheres, and may be made of electrically conductive material obtained by conventional flip-chip bumping. While bumps are shown, it is understood by one of ordinary skill in the art that any plurality of electrical contacts **8,** including but not limited to pins and leads, or the like may be used.

Ball gate array (BGA) balls **3** extend from the bottom of substrate **2** and functionally connect second surface **15** of substrate **2,** typically by metallic traces and vias through substrate **2.** BGA balls **3** may carry power and input/output signals to die 6 (through electrical contacts **8**), and any other components on substrate **2.** One of ordinary skill will recognize that substrate **2** may include a bond pad, a copper bump holder to improve conductivity (not shown). What is also contemplated is any bumping method including but not limited to solder bumping, stud bumping, plate bumping, or even adhesive bumping.

An encapsulant retention structure **4** is further attached to or extends from first surface **14** of substrate **2.** Encapsulant retention structure **4** may, for example, be bonded to surface **14** by a layer of adhesive **5.** As will be appreciated, any type of adhesive **5** used in the industry including but not limited to natural adhesive, synthetic adhesive, drying adhesives, thermoplastic adhesives, reactive adhesives, pressure sensitive adhesives, or any other commonly used adhesive. Die **6** is positioned generally beside encapsulant retention structure **4.** An encapsulant **7** is interposed between at least a portion of die **6** and encapsulant retention structure **4.**

As detailed below, encapsulant retention structure **4** may further act as a stiffener reinforcing the rigidity of substrate **2,** and therefore the integrated circuit package **1.** As such, in reference to at least some embodiments, encapsulant retention structure **4** is referred to as a stiffener.

As detailed below, encapsulant **7** may be flowed between die **6** and the top surface **14** of substrate **2** to bond die **6** to substrate **2.** Encapsulant **7** may further occupy at least a portion of the region laterally between die **1** and encapsulant retention structure **4.** As illustrated in **FIGS. 1** and **2****,** encapsulant **7** is thus in contact with encapsulant retention structure **4,** and the bottom and sides of die **6.** As such, die **6** is supported on its bottom and four sides, by encapsulant **7.** Conveniently, encapsulant **7** may thus provide lateral support to die **6** along the edges of die **6,** and further fill the gap between the bottom surface of die **6** and substrate **2.** Typically die **6** has four edges, and encapsulant **7** thus supports die **6** on its bottom surface and its four edges. Of course, die **6** could have more edges, all supported by encapsulant **7.** Encapsulant **7,** in turn is supported by substrate **7** and encapsulant retention structure **4.**

Encapsulant retention structure **4** may be formed as a plurality of segments, or integrally, as long as the encapsulant retention structure **4** is able to retain encapsulant **7** within the area adjacent to the die **6,** and in particular where seeping may occur before encapsulant **7** cures.

As noted, encapsulant retention structure **4** may also conveniently act as a stiffener for substrate **2,** and thus package **1.** That is, encapsulant retention structure **4** may be made more rigidly than substrate **2,** and attached to substrate **2.** For example, encapsulant retention structure **4** could be formed of woven fiberglass mat impregnated with a flame retardant epoxy resin such as FR-4 or BT resin. Alternatively encapsulant retention structure **4** may be formed of the same material as substrate **2,** and may be made thicker. For example encapsulant retention structure **4** may be formed of the same material as substrate **2** (e.g. FR-2, FR-4 or BT). Of course, as will be understood by those of ordinary skill in the art, any low-cost structure, laminated structure, or other insulation material possessing sufficient mechanical strength and thermal resistance, such as polymers, may be placed on the substrate **2** . Retention structure **4** may, for example, have a thickness of about 500 to 1000 microns. In other embodiments, the retention structure **4** acting as stiffener has a thickness less than the thickness of die **6** mounted on substrate **2** by electrical contacts **8.**

A thermal diffusion device (not shown), such as a heat sink, heat fins, a vapor chamber, or any combination thereof, may further be coupled to the upper surface of die **6.**

The packages integrated chip 6 as shown in Fig. 1 may be an IC die, a microprocessor, a network processor, or a transceiver having a silicon substrate or any other miniaturized electronic circuit placed on an insulating platform and housed within a package. In one embodiment, encapsulant **7** is initially placed by a dispensing device including an underfilling needle. The device may dispense encapsulant **7** along the edges of die **6** between die **6** and encapsulant retention structure **4.** Encapsulant **7** as shown in **FIG. 1** seeps to occupy the area located between the plurality of electrical contacts **8** of die **6.** Conveniently, encapsulant **7** may be dispensed anywhere in the region between retention structure **4** and die **6.** Encapsulant **7** may thermally and mechanically couple die **6** to substrate **2** and to protect the coupling zone and the electrical contacts **8** from environmental hazards. In one preferred embodiment, encapsulant **7** is an underfill typically used in underfilling processes, and the underfill may be made of snap cure, low profile, high performance, or reworkable types. As will be appreciated, at a minimum, any commercially available material suitable as underfill can be used and any commercially available dispensing equipment may be used.

Conveniently, encapsulant **7** may shield connections **8** in the presence of differing coefficients of thermal expansions of die **6** and substrate **2.** Advantageously, by supporting die **6** laterally, along sides of die **6** the durability of package **1** may be further improved.

**FIG. 2** is an enlarged fragmentary cross-sectional view of integrated circuit package **1** as shown by section **2** in **FIG. 1****.** As illustrated liquid underfill encapsulant **7** as shown in **FIG. 2** is placed between encapsulant retention structure **4** and packaged die **6** where encapsulant **7** is initially at a first level (not shown). As seeping occurs, encapsulant **7** migrates between electrical contacts **8** to fill a void located beneath die **6.** As the seeping advances, level **13** will lower and eventually come to an equilibrium at, for example, a position shown in **FIG. 2****.** A portion of side wall **10** of die **6** may then be above level **13,** and a section **12** of encapsulant retention structure **4** below level **13.** A second section **11** of encapsulant retention structure **4** is located above level **13.** It is understood by one of ordinary skill in the art that while encapsulant retention structure **4** shown as a layer placed on the substrate **2,** affixed with the adhesive **5,** any stiffener, ribbing structure, hollowed network, pods, or small pillar is contemplated. In one embodiment, die **6** has a side wall **10,** and encapsulant **7** is in contact with side wall **10** and encapsulant retention structure **4.**

Conveniently, in the presence of encapsulant retention structure **4,** a less viscous encapsulant may be used. As such, assembly of semiconductor chip package **1** may be performed more quickly than conventionally. For example, in the presence of retention structure **4,** encapsulant **7** can be dispensed without multiple passes and improve expedite manufacturing. Without encapsulant retention structure **4,** encapsulant may seep out requiring that encapsulant be dispensed slowly, and in several doses or passes.

In an embodiment, substrate **2** has a thickness of about 70 to 400 microns. In other embodiments, substrate **2** may have a thickness of about 400 microns, or less. It is understood by one of ordinary skill that while a specific thickness is disclosed as an embodiment, reduction of the thickness of substrate **2** is desirable. As such, substrate **2** could have a thickness of less than 70 microns. In another embodiment, substrate **2** may be a thin core substrate, a substrate with no core, or a polyimide tape substrate.

**FIG. 3** shows a side cross-sectional view of an integrated circuit package **1'** with openings for passive electronic components, exemplary of another embodiment of the present invention. Components that are the same as, or substantially the same as components of package **1** (**FIGS. 1** and **2**) are numbered using like numerals as in **FIGS. 1** and **2****,** but with a prime (') symbol. The integrated circuit package **1'** includes substrate **2',** a die **6'** coupled to substrate **2',** and at least one passive electronic component **20** coupled to the substrate **2'.** Passive electronic component **20** may be a capacitor, resistor, inductor, or the like. A retention structure **4'** in the form of a stiffener has a top surface **21** and a bottom surface **23.** The bottom surface **23** is coupled to substrate **2'** with an adhesive **5'.** Retention structure **4'** surrounds or partly surrounds passive electronic component **20,** mounted on substrate **2'.**

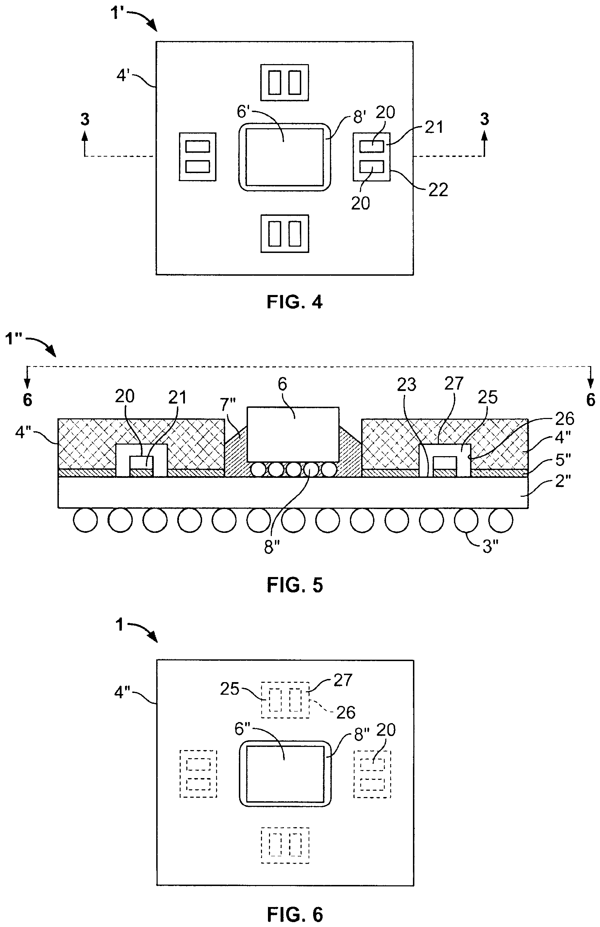

**FIG. 4** is a top view of integrated circuit package **1'** of **FIG. 3****.** As illustrated, retention structure **4'** covers substantially all of the top surface of substrate **2'.** As further illustrated, retention structure **4'** includes rectangular opening **22** formed in retention structure **4'** surrounding the at least one passive electronic component **20.** **FIG. 3** shows a configuration where the opening made in the stiffener/retention structure **4'** is a rectangular hole throughout the full height of the stiffener/retention structure **4'.**

In yet another embodiment shown in **FIGS. 5** and **6****,** a recessed section or cavity **26** is made in the bottom surface **23** of a retention structure **4"** (like encapsulant retention structure **4'** of **FIGS. 3** and **4**). Retention structure **4"** thus covers passive components **20,** so that these are not visible from above.

While two possible embodiments are shown, any opening made in a retention structure **4"** that surrounds or partly surrounds the at least one passive electronic component **20** may be provided, including but not limited to direct molding of the stiffener over passive electronic component **20,** the pressure insertion of the passive electronic component **20** into a viscous stiffener material, or the machining of an opening of any geometry able to surround passive electronic component **20.** In one embodiment, passive electronic component **20** is a pair of capacitors placed on each of four lateral sides of die **6.** Of course, a plurality of openings, holes, recesses, and other cavities may be made in stiffener/retention structure **4"** during manufacturing while still maintaining satisfactory mechanical resistance or stiffness of a thinned substrate **2"** with the use of a layer of substrate **2".** What is also contemplated is any known fixation method to functionally couple passive electronic component **20** to substrate **2"** shown as reference **21** in **FIG. 5****.** As will be appreciated, an encapsulant **7** may also be placed within the rectangular opening **22,** whose edges act as a retention wall around passive component **20.**

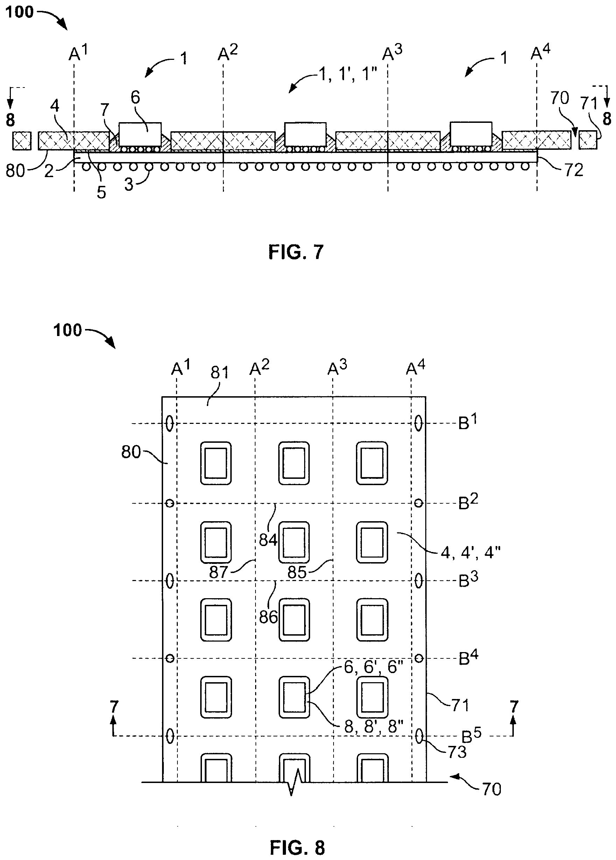

Conveniently integrated circuit package **1, 1', 1"** of **FIGS. 1-6** may be formed by singulating one or two dimensional strips. For example, as illustrated in **FIGS. 7** and **8****,** an integrated circuit package strip **100** is made to form a plurality of integrated circuit packages **1, 1',** or **1"** shown individually in **FIGS. 1-6** according to several preferred embodiments. Each integrated circuit package **1, 1', 1"** is arranged in a plane along a strip **71.** Integrated circuit package **1, 1', 1"** includes substrate **2, 2', 2"** with a first surface **14** as shown in **FIG. 1****.** Die **6, 6'** or **6"** is coupled to the first surface **14,** and a stiffener/retention structure **4, 4'** or **4"** surrounds die **6, 6'** or **6"** is further coupled to first surface **14,** and at least one integrated circuit package **1, 1'** or **1"** in strip **100** has four lateral sections perpendicular to the plane and sharing at least two of the four lateral sections with different integrated circuit package along strip **100.**

**FIGS. 7** and **8** further illustrates cut lines **A1** to **A4** along a longitudinal direction of strip **100** and cut lines **B1** to **B5** along a latitudinal direction of strip **100.** These cut lines are shown on strip **100** to indicate the position of the integrated circuit packages **1, 1', 1"** after each package is singulated from strip **100** using, for example, conventional cutting methods such as but not limited to saw singulated cutting techniques or punch singulated techniques. In one embodiment, each package **1, 1', 1"** is cut from strip **100** using a saw.

In the embodiment shown in **FIG. 8****,** a matrix or array of integrated circuit packages **1, 1', 1"** is shown. As illustrated, the array is 3 packages wide, and may have an arbitrary length. A practical embodiment may be formed as a 3-by-10 matrix. Of course, any arrangement of integrated circuit packages **1, 1', 1"** including but not limited to a strip of one dimension or a two-dimensional array is possible. For strip **100,** each of the four lateral edges **84, 85, 86, 87** around at least some integrated circuit packages **1, 1', 1"** shown as the preferred embodiment, are disposed in contact with adjacent integrated circuit packages **1, 1', 1"** to form a configuration where a cut along each edge at least partially separates two (2) adjacent packages **1, 1', 1"** from strip **100.**

**FIG. 7** illustrates an embodiment where encapsulant retention structure **4** or the stiffener is of greater planar dimension than substrate **2** creating a circumferential edge **80,** which is better shown in **FIG. 8****.** Circumferential edge **80** is used during the manufacturing process to manipulate substrate **4.** Guides are used to center and position substrate **2** next to encapsulant retention structure **4.** **FIG. 7** shows a series of indexing holes **70** made in circumferential edge **80,** but what is contemplated is any guide, including but not limited to notches, pins, geometric variations, thickness variations, magnetic locks, or other similar devices known in the art. In one preferred embodiment, the outer cuts, namely cuts A1, A4, and B1, are designed to separate circumferential edge **80** from center region of strip **100** and align outer edge **71** of strip **100** with substrate **2.** In a preferred embodiment, tolerances observed are around **75** microns or less between the outer edge of the substrate **2** and the outer edge of the stiffener/retaining structure **4, 4'** or **4".** What is also shown is a configuration where die **6, 6',** or **6"** is centered in the middle of each integrated circuit package **1, 1'** or **1",** and alternatively but not shown, where openings for a passive electronic component **20** are also centered between die **6, 6'** or **6"** and the lateral edge. It is understood by one of ordinary skill in the art that the arrangement of the different elements and components on substrate **2** within each integrated circuit package **1, 1'** or **1"** may be different according to functional needs, thermal requirements, or even mechanical resistance obligations.

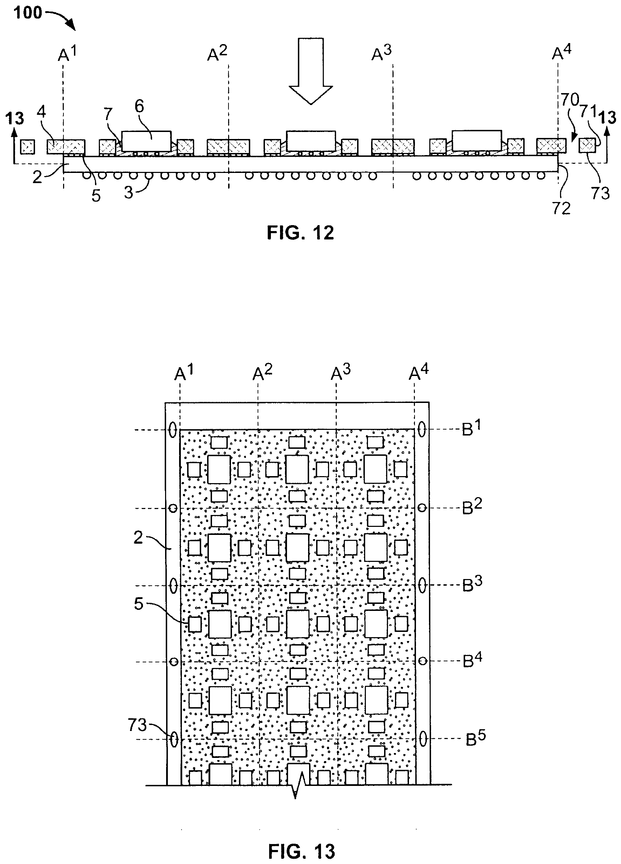

**FIG. 13** shows as a preferred embodiment the location of the adhesive **5** placed upon the surface of the stiffener/encapsulant retention structure **4** in accordance with the above described embodiments. As will be understood, while adhesive **5** is shown as a significant layer, a thin layer of adhesive is typically used based on bonding properties of the selected adhesive **5.** In the embodiment of **FIG. 13****,** circumferential edge **80** need not be covered with adhesive **5,** since circumferential edge **80** is to be separated and discarded during cutting operations. Of course, the placement of adhesive **5** over the entire surface of stiffener/retention structure **4** is also possible.

Of note, **FIGS. 4, 6****,** **8****,** and **13** each illustrate embodiments where a package **1, 1', 1"** is rectangular in shape and includes a die **6, 6', 6"** also of rectangular shape in a horizontal plane. While rectangular shapes are generally preferred in this art, any geometry is possible.

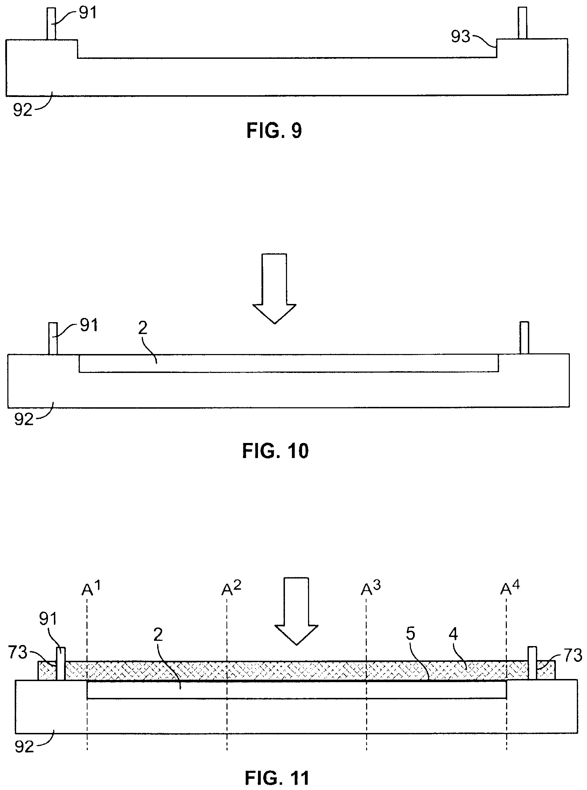

**FIGS. 9** to **12** are elevation schematic views of a method for making an integrated package strip, like strip **100,** exemplary of an embodiment of the present disclosure where each elevation represents a different successive step in the process of making the integrated package strip. As illustrated in **FIGS. 9** and **10****,** a layer of substrate **2** is inserted in an alignment structure such as an alignment structure **92.** A recess **93** in alignment structure **92** may hold substrate **2** both longitudinally and laterally with edges of a thickness sufficient to house the substrate **2,** as illustrated in **FIG 10****.** A series of tooling pins **91** formed on alignment structure **92** may further receive the stiffener/encapsulant retention structure **4.**

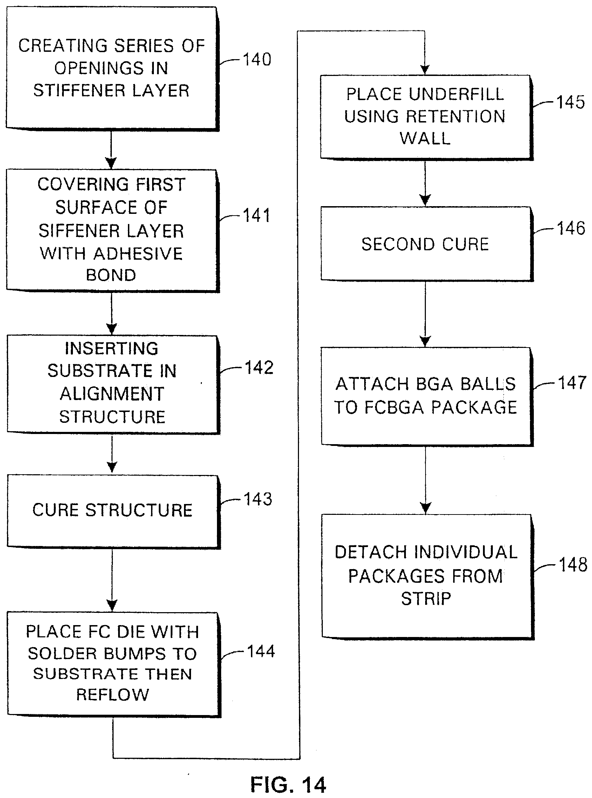

**FIG. 14** is a flow chart illustrating a method of making an integrated package strip, and individual integrated circuit package **1,** exemplary of an embodiment of the present invention. Each block is shown in succession. As illustrated, a stiffener layer is prepared, by creating a series of openings in a sheet made of suitable stiffener material. A first surface of the stiffener layer is covered with an adhesive **5** in block **141.** A sheet of substrate **2** is placed on alignment structure **92** in block **142,** as depicted in **FIG. 10****.** Stiffener/retention structure **4** is then placed on substrate **2** on alignment structure **92** so that the first surface is in contact with substrate **2** resulting in a substrate/stiffener sub-assembly shown in **FIG. 11** for the strip. Adhesive **5** may be cured in block **143.** Next, in block **144,** dies **6** with solder bumps are place on complementary under-bump metallization (not shown) on substrate **2.** Bumps **8** are also reflowed in block **144.** Stiffener/retention structure **4** may, also include a series of indexing holes **73** for placement of the stiffener layer over the alignment structure **92.**

Underfill 7 is placed using the retention wall in block **145** before a second cure is conducted in block **146.** BGA balls **3** may then be attached in block **147** to the flip chip BGA package. Finally, individual package **1** may be detached from the packaged strip **100.**

**FIG. 12** illustrates strip **100** with a series of openings made the stiffener layer to house a packaged die **6.** The edge of stiffener layer **80** may then be cut to remove indexing holes **73** or any other holding or guiding means. Die **6** may then be functionally coupled in block **144** in each opening after a cure by placing die **6** and solder bumps on substrate **2** before reflow. In yet another embodiment, a series of opening may be created in the stiffener layer to house a passive electronic component **20** coupled to the substrate **2.**

As will be appreciated, in alternate embodiments, the order of blocks may be altered, or supplemented with other blocks. For example, individual integrated circuit packages may be separated from strip **100** before the BGA balls **3** are attached to an integrated circuit package from the strip.

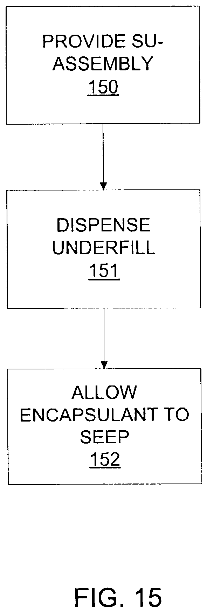

**FIG. 15** is a flow chart of a method for making an integrated package **1,** in accordance with an embodiment of the present disclosure. As illustrated, in block **150,** a sub-assembly including a substrate **2** having a first surface **14** and a second surface **15** in opposition to the first surface **14,** an encapsulant retention structure **4** coupled to first surface **14,** and a die **6** with a side wall positioned adjacent to the encapsulant retention structure **4** also having a bottom surface at a distance from first surface **14,** is provided. The sub-assembly may be as depicted in **FIGS. 1** and **2****,** but without encapsulant. The method further includes the step of placing an encapsulant **7** between side wall and the encapsulant retention structure **4** in block **151,** and allowing the encapsulant **7** to seep between the bottom surface and the first surface **14** in block **152.** Encapsulant **7** may be placed in a single operation, or in several steps. Conveniently, a reduction of normal operations during the placement of the encapsulant **7** in the integrated circuit package **1** is contemplated.

Of course, methods depicted in **FIGS. 14** and **15** may be used to form integrated circuit package **1, 1', 1"** or other packages.

## Claims

1. An integrated circuit package (1; 1'; 1"), comprising:
a substrate (2; 2'; 2");
a packaged integrated chip (6; 6'; 6") coupled to the substrate;
at least one passive electronic component (20) coupled to the substrate; and
**characterized in that** the integrated circuit package comprises a stiffener (4; 4'; 4") comprising a top surface (21) and a bottom surface (23), the bottom surface coupled to the substrate and having a space at least partially surrounding the at least one passive electronic component, wherein the stiffener is configured to retain an encapsulant within an area between a side wall of the packaged integrated chip and a section of the stiffener adjacent to the side wall.

2. The integrated circuit package (1; 1'; 1") of claim 1, wherein the bottom surface (23) is recessed and houses the at least one passive electronic component (20).

3. The integrated circuit package (1; 1'; 1") of claim 1, wherein the stiffener (4; 4'; 4") is comprised of a epoxy resin reinforced with a woven fibreglass mat.

4. The integrated circuit package (1; 1'; 1") of claim 1, wherein the substrate (2; 2'; 2") has a thickness of about 70 to 400 microns.

5. The integrated circuit package (1; 1'; 1") of claim 1, wherein the substrate (2; 2'; 2") has a thickness of about 400 microns.

6. The integrated circuit package (1; 1'; 1") of claim 1, wherein the substrate (2; 2'; 2") is a thin core substrate structure.

7. The integrated circuit package (1; 1'; 1") of claim 1, wherein the substrate (2; 2'; 2") is a substrate structure with no core.

8. The integrated circuit package (1; 1'; 1") of claim 1, wherein the substrate (2; 2'; 2") is a polyimide tape substrate.

9. The integrated circuit package (1; 1'; 1") of claim 1, wherein the package insulated circuit is integrated in a flip-chip ball grid array.

10. The integrated circuit package (1; 1'; 1") of claim 1, wherein the stiffener (4; 4'; 4") has a thickness of about 500 to 1000 microns.

11. The integrated circuit package (1; 1'; 1") of claim 10, wherein the packaged integrated chip (6; 6'; 6") has a thickness greater than the thickness of the stiffener (4; 4'; 4").

12. The integrated circuit package (1; 1'; 1") of claim 11, wherein a heat sink is attached to a top side of the packaged integrated chip (6; 6'; 6").

13. The integrated circuit package (1; 1'; 1") of claim 1, wherein the at least one passive electronic component is a capacitor.

14. The integrated circuit package (1; 1'; 1") of claim 2, comprising an encapsulant interposed between at least a portion of the packaged integrated chip (6; 6'; 6") and the stiffener and in contact with the stiffener (4; 4'; 4").

## Patentansprüche

1. Integrierte Schaltungspackung (1; 1'; 1"), umfassend:
ein Substrat (2; 2'; 2");
einen verpackten integrierten Chip (6; 6'; 6"), der mit dem Substrat gekoppelt ist;
mindestens eine passive elektronische Komponente (20), die mit dem Substrat gekoppelt ist; und
**dadurch gekennzeichnet, dass** die integrierte Schaltungspackung ein Versteifungselement (4; 4'; 4") umfasst, das eine Oberseite (21) und eine Unterseite (23) umfasst, wobei die Unterseite mit dem Substrat gekoppelt ist und einen Zwischenraum aufweist, der die mindestens eine passive elektronische Komponente zumindest teilweise umgibt, wobei das Versteifungselement dazu konfiguriert ist, eine Verkapselung innerhalb eines Bereichs zwischen einer Seitenwand des verpackten integrierten Chips und einem Abschnitt des Versteifungselements benachbart zu der Seitenwand zu halten.

2. Integrierte Schaltungspackung (1; 1'; 1") nach Anspruch 1, wobei die Unterseite (23) vertieft ist und die mindestens eine passive elektronische Komponente (20) aufnimmt.

3. Integrierte Schaltungspackung (1; 1'; 1") nach Anspruch 1, wobei das Versteifungselement (4; 4'; 4") aus einem mit einer gewebten Glasfasermatte verstärkten Epoxidharz besteht.

4. Integrierte Schaltungspackung (1; 1'; 1") nach Anspruch 1, wobei das Substrat (2; 2'; 2") eine Dicke von etwa 70 bis 400 Mikrometern aufweist.

5. Integrierte Schaltungspackung (1; 1'; 1") nach Anspruch 1, wobei das Substrat (2; 2'; 2") eine Dicke von etwa 400 Mikrometern aufweist.

6. Integrierte Schaltungspackung (1; 1', 1") nach Anspruch 1, wobei das Substrat (2; 2'; 2") eine dünne Kernsubstratstruktur ist.

7. Integrierte Schaltungspackung (1; 1'; 1") nach Anspruch 1, wobei das Substrat (2; 2'; 2") eine Substratstruktur ohne Kern ist.

8. Integrierte Schaltungspackung (1; 1'; 1") nach Anspruch 1, wobei das Substrat (2; 2'; 2") ein Polyamidbandsubstrat ist.

9. Integrierte Schaltungspackung (1; 1'; 1") nach Anspruch 1, wobei die packungsisolierte Schaltung in eine Flipchip-Kugelgitteranordnung integriert ist.

10. Integrierte Schaltungspackung (1; 1'; 1") nach Anspruch 1, wobei das Versteifungselement (4; 4'; 4") eine Dicke von etwa 500 bis 1000 Mikrometern aufweist.

11. Integrierte Schaltungspackung (1; 1'; 1") nach Anspruch 10, wobei der verpackte integrierte Chip (6; 6'; 6") eine Dicke aufweist, die größer als die Dicke des Versteifungselements (4; 4'; 4") ist.

12. Integrierte Schaltungspackung (1; 1'; 1") nach Anspruch 11, wobei eine Wärmesenke an einer Oberseite des verpackten integrierten Chips (6; 6'; 6") befestigt ist.

13. Integrierte Schaltungspackung (1; 1'; 1") nach Anspruch 1, wobei die mindestens eine passive elektronische Komponente ein Kondensator ist.

14. Integrierte Schaltungspackung (1; 1'; 1") nach Anspruch 2, umfassend eine Verkapselung, die zwischen zumindest einem Abschnitt des verpackten integrierten Chips (6; 6'; 6") und dem Versteifungselement und in Kontakt mit dem Versteifungselement (4; 4'; 4") angeordnet ist.

## Revendications

1. Boîtier de circuit intégré (1 ; 1' ; 1")
comprenant:
un substrat (2 ; 2' ; 2") ;
une puce intégrée en boîtier (6 ; 6' ; 6") couplée au substrat ; au moins un composant électronique passif (20) couplé au substrat ; et **caractérisé en ce que** le boîtier de circuit intégré comprend un raidisseur (4 ; 4' ; 4") comprenant une surface supérieure (21) et une surface inférieure (23), la surface inférieure étant couplée au substrat et comportant un espace entourant au moins partiellement l'au moins un composant électronique passif, dans lequel le raidisseur est configuré pour retenir un agent d'encapsulation une zone entre une paroi latérale de la puce intégrée en boîtier et une section du raidisseur adjacente à la paroi latérale.

2. Boîtier de circuit intégré (1 ; 1' ; 1") selon la revendication 1, dans lequel la surface inférieure (23) est en retrait et abrite l'au moins un composant électronique passif (20) .

3. Boîtier de circuit intégré (1 ; 1' ; 1") selon la revendication 1, dans lequel le raidisseur (4 ; 4' ; 4") est constitué d'une résine époxy renforcée avec une toile tissée de fibre de verre.

4. Boîtier de circuit intégré (1 ; 1' ; 1") selon la revendication 1, dans lequel le substrat (2; 2'; 2") possède une épaisseur d'environ 70 à 400 microns.

5. Boîtier de circuit intégré (1 ; 1' ; 1") selon la revendication 1, dans lequel le substrat (2 ; 2' ; 2") possède une épaisseur d'environ 400 microns.

6. Boîtier de circuit intégré (1 ; 1' ; 1") selon la revendication 1, dans lequel le substrat (2; 2'; 2") est une structure de substrat à âme mince.

7. Boîtier de circuit intégré (1 ; 1' ; 1") selon la revendication 1, dans lequel le substrat (2 ; 2' ; 2") est une structure de substrat sans âme.

8. Boîtier de circuit intégré (1 ; 1' ; 1") selon la revendication 1, dans lequel le substrat (2; 2'; 2") est un substrat de film polymide.

9. Boîtier de circuit intégré (1 ; 1' ; 1") selon la revendication 1, dans lequel le circuit isolé du boîtier est intégré dans une matrice de billes à puce retournée.

10. Boîtier de circuit intégré (1 ; 1' ; 1") selon la revendication 1, dans lequel le raidisseur (4 ; 4' ; 4") possède une épaisseur d'environ 500 à 1 000 microns.

11. Boîtier de circuit intégré (1 ; 1' ; 1") selon la revendication 10, dans lequel la puce intégrée en boîtier (6 ; 6' ; 6") possède une épaisseur supérieure à l'épaisseur du raidisseur (4 ; 4' ; 4").

12. Boîtier de circuit intégré (1 ; 1' ; 1") selon la revendication 11, dans lequel un dissipateur de chaleur est fixé sur un côté supérieur de la puce intégrée en boîtier (6 ; 6' ; 6").

13. Boîtier de circuit intégré (1 ; 1' ; 1") selon la revendication 1, dans lequel l'au moins un composant électronique passif est un condensateur.

14. Boîtier de circuit intégré (1 ; 1' ; 1") selon la revendication 2, comprenant un encapsulant interposé entre au moins une partie de la puce intégrée en boîtier (6 ; 6' ; 6") et le raidisseur et en contact avec le raidisseur (4 ; 4' ; 4").
